# EUROPEAN PATENT APPLICATION

(11) **EP 2 020 691 A2**
(43) Date of publication of application: **04.02.2009**
(21) Application number: 08161500.7
(22) Date of filing: 30.07.2008
(51) Int. Cl.: H01L 33/00, H01L 21/20

(54) **III-Nitride semiconductor light emitting device**

(30) Priority: 31.07.2007 KR 20070077218; 22.10.2007 KR 20070106275
(71) Applicant: Epivalley Co., Ltd., Gumi-city, Gyungbuk 730-030 (KR)
(72) Inventor: Park, Joong Seo, Yongin-si, 448-785, Gyeonggi-do (KR)
(74) Representative: Schmitt, Armand

(57) **Abstract**

The present invention provides a III-nitride semiconductor light emitting device, including: a plurality of III-nitride semiconductor layers including an active layer for generating light by recombination of electrons and holes; and a substrate used to grow the plurality of III-nitride semiconductor layers, and including a protrusion with two opposite sides rounded.

## Description

### [Technical Field]

The present invention relates to a III-nitride semiconductor light emitting device, and more particularly, to a III-nitride semiconductor light emitting device which can not only solve a lateral constraint of a protrusion but also improve crystallinity.

The III-nitride semiconductor light emitting device means a light emitting device such as a light emitting diode including a compound semiconductor layer composed of Al₍ₓ₎Ga_{(y)}In_{(1-x-y)}N (0≤x≤1, 0≤y≤1, 0≤x+y≤1), and may further include a material composed of other group elements, such as SiC, SiN, SiCN and CN, and a semiconductor layer made of such materials.

### [Background Art]

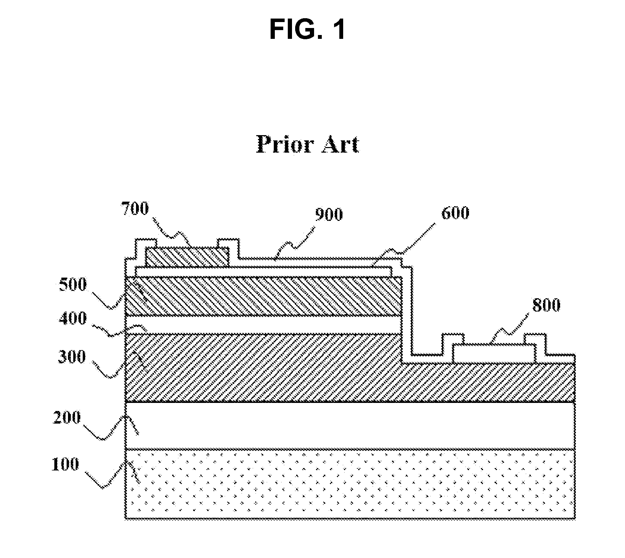

FIG. 1 is a view illustrating an example of a conventional III-nitride semiconductor light emitting device. The III-nitride semiconductor light emitting device includes a substrate 100, a buffer layer 200 epitaxially grown on the substrate 100, an n-type nitride semiconductor layer 300 epitaxially grown on the buffer layer 200, an active layer 400 epitaxially grown on the n-type nitride semiconductor layer 300, a p-type nitride semiconductor layer 500 epitaxially grown on the active layer 400, a p-side electrode 600 formed on the p-type nitride semiconductor layer 500, a p-side bonding pad 700 formed on the p-side electrode 600, an n-side electrode 800 formed on the n-type nitride semiconductor layer exposed by mesa-etching the p-type nitride semiconductor layer 500 and the active layer 400, and a protective film 900.

FIG. 2 is a view illustrating a light emitting device disclosed in International Publication WO02/75821 and WO03/10831, particularly, showing a process of growing a nitride semiconductor layer 410 on a patterned substrate 400. The nitride semiconductor layers 410 start to grow on lower and upper surfaces of the patterned substrate 400, respectively, and are brought into contact with each other. The growth of the nitride semiconductor layer 410 is facilitated in the contact portions to thereby form a flat surface. Since the patterned substrate 400 is used, light is scattered to improve external quantum efficiency, and crystal defects are reduced to improve quality of the nitride semiconductor layer 410.

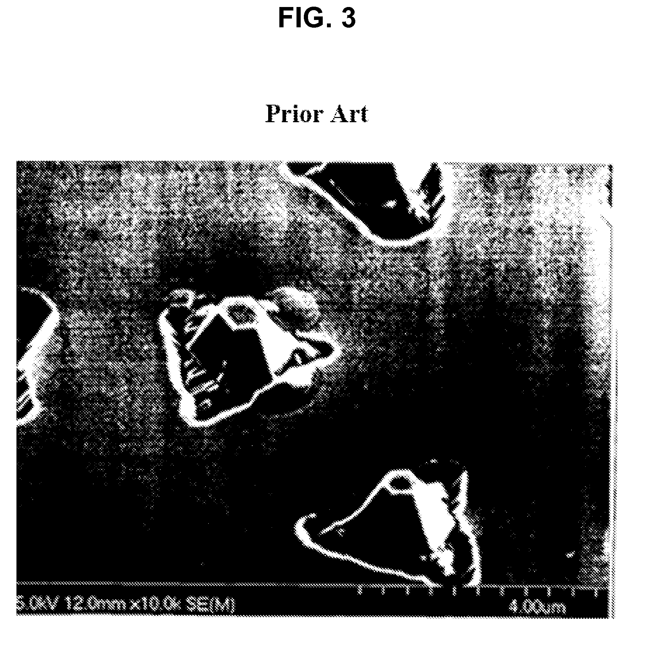

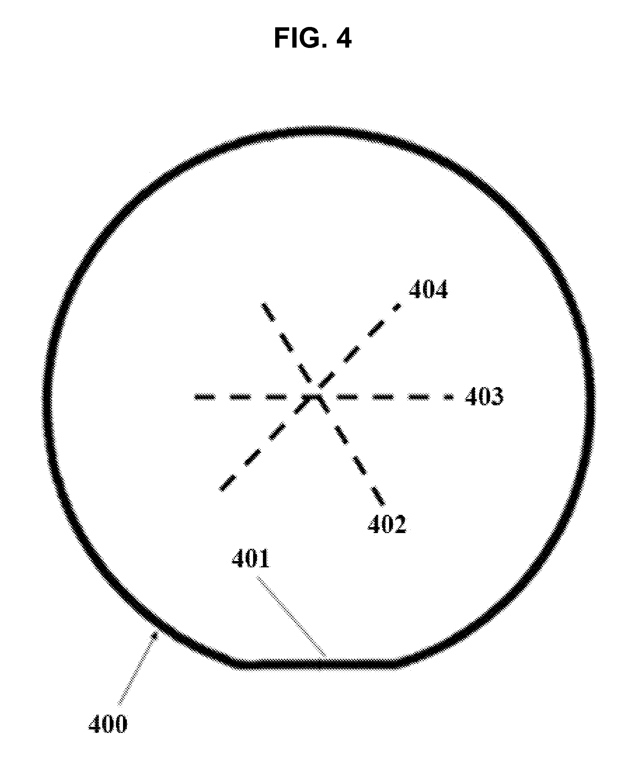

FIG. 3 is a view illustrating an example of a protrusion disclosed in WO03/10831, particularly, a protrusion with a hexagonal cross-section on a substrate. Meanwhile, according to WO03/10831, in a case where the side of the protrusion is positioned in parallel with a stably growing face of a nitride semiconductor (e.g., a flat zone 401 of a substrate; refer to FIG. 4), the nitride semiconductor grows slowly, which results in increase of crystal defects. So as to decrease the crystal defects, the entire sides of the protrusion are formed, crossing the stably growing face. Such a lateral constraint of the protrusion makes it difficult to form protrusions and/or depressions on the substrate to improve crystallinity.

FIG. 4 is an explanatory view illustrating stably growing faces of a nitride semiconductor, particularly, three stably growing faces 402, 403 and 404 with an angular difference of 60 ° on a C-surface sapphire substrate 400.

### [Disclosure]

### [Technical Problem]

Accordingly, the present invention has been made to solve the above-described shortcomings occurring in the prior art, and an object of the present invention is to provide a III-nitride semiconductor light emitting device which can solve the foregoing problems.

Another object of the present invention is to provide a III-nitride semiconductor light emitting device which can not only solve a lateral constraint of a protrusion but also improve crystallinity.

A further object of the present invention is to provide a III-nitride semiconductor light emitting device which can improve external quantum efficiency by adjusting an angle of a scribing line to a substrate having a protrusion.

A still further object of the present invention is to provide a III-nitride semiconductor light emitting device which can secure a sufficient space for growing a nitride semiconductor on a substrate.

### [Technical Solution]

To this end, according to an aspect of the present invention, there is provided a III-nitride semiconductor light emitting device including: a plurality of III-nitride semiconductor layers including an active layer for generating light by recombination of electrons and holes; and a substrate used to grow the plurality of III-nitride semiconductor layers, and including a protrusion with two opposite sides rounded.

According to another aspect of the present invention, the protrusion includes two connection sides for connecting the two opposite rounded sides. Preferably, the two connection sides are composed of straight lines, but may be slightly outwardly or inwardly curved in accordance with its mask pattern.

According to a further aspect of the present invention, the substrate is divided by at least one cutting surface, and extension lines of the two connection sides cross the at least one cutting surface. Here, the at least cutting surface defines the contour of the light emitting device, and may be formed by means of a diamond cutting or scribing/breaking process.

According to a still further aspect of the present invention, the substrate includes a first array with a plurality of protrusions formed thereon, and a second array with a plurality of protrusions formed thereon, and the plurality of protrusions of the first array and the plurality of protrusions of the second array are arranged in alternate positions.

### [Advantageous Effects]

According to the present invention, the III-nitride semiconductor light emitting device can not only solve a lateral constraint of a protrusion but also improve crystallinity.

According to the present invention, the III-nitride semiconductor light emitting device can improve external quantum efficiency by adjusting an angle of a scribing line to a substrate having a protrusion.

According to the present invention, the III-nitride semiconductor light emitting device can improve crystallinity of a nitride semiconductor layer by securing a sufficient space for growing a nitride semiconductor on a substrate.

### [Description of Drawings]

FIG. 1 is a view illustrating an example of a conventional III-nitride semiconductor light emitting device.

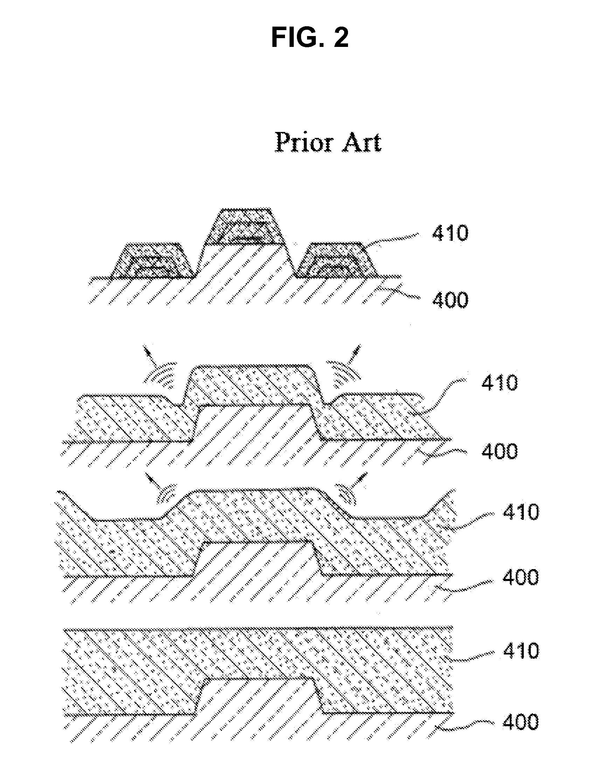

FIG. 2 is a view illustrating a light emitting device disclosed in International Publication WO02/75821 and WO03/10831.
FIG. 3 is a view illustrating an example of a protrusion disclosed in WO03/10831.
FIG. 4 is an explanatory view illustrating stably growing faces of a nitride semiconductor.
FIG. 5 is a view illustrating an example of a III-nitride semiconductor light emitting device according to the present invention.
FIG. 6 is an explanatory view illustrating shape and arrangement of protrusions according to the present invention.
FIGS. 7 and 8 are explanatory views illustrating an example of a process of forming protrusions according to the present invention.
FIG. 9 is a view illustrating an example of protrusions according to the present invention.
FIG. 10 is an optical microscope photograph showing a GaN epitaxial layer grown on a prepared substrate according to the present invention.
FIG. 11 is an explanatory view illustrating the relationship between a light emitting device and a scribing line.
FIG. 12 is a graph showing a simulation result of analyzing light extraction efficiency variations by an angle y, using a quadrangular pyramidal protrusion with a base of 4.5 µm × 3 µm.
FIG. 13 is a view illustrating another example of arrangement of protrusions according to the present invention.

### [Mode for Invention]

Hereinafter, the present invention will be described in detail with reference to the accompanying drawings.

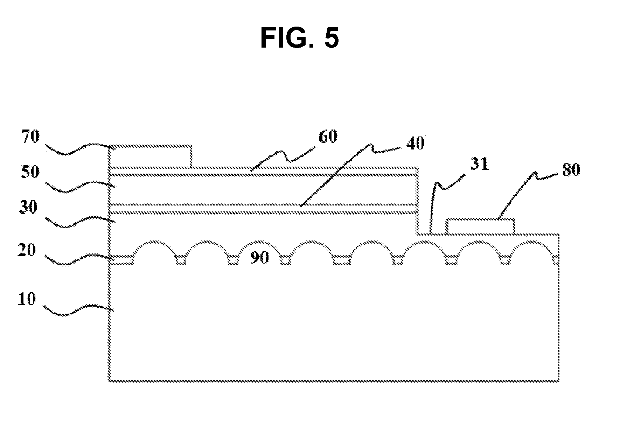

FIG. 5 is a view illustrating an example of a III-nitride semiconductor light emitting device according to the present invention. The III-nitride semiconductor light emitting device includes a sapphire substrate 10 with protrusions 90 formed thereon, a buffer layer 20 grown on the sapphire substrate 10, an n-type nitride semiconductor layer 30 grown on the buffer layer 20, an active layer 40 grown on the n-type nitride semiconductor layer 30, a p-type nitride semiconductor layer 50 grown on the active layer 40, a light transmitting electrode 60 formed on the p-type nitride semiconductor layer 50, a p-side electrode 70 formed on the light transmitting electrode 60, and an n-side electrode 80 formed on an n-type nitride semiconductor layer 31 exposed by mesa-etching the p-type nitride semiconductor layer 50 and the active layer 40.

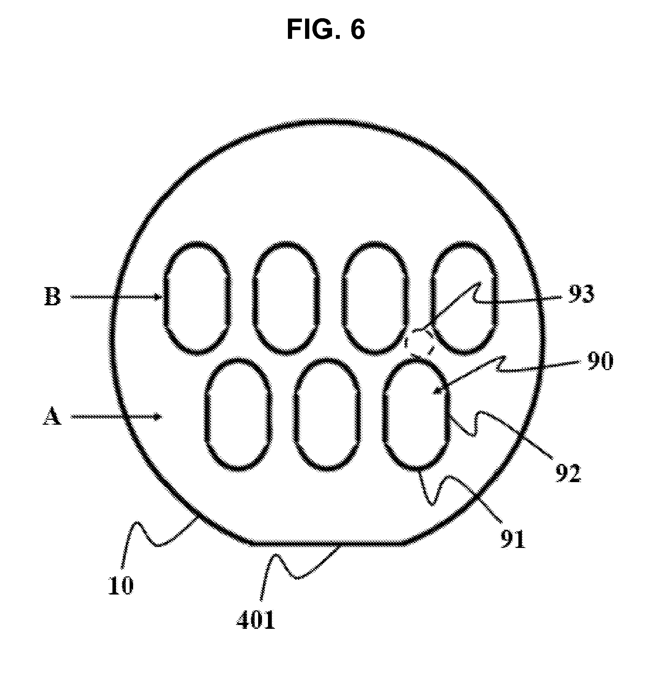

FIG. 6 is an explanatory view illustrating shape and arrangement of protrusions according to the present invention. The protrusions 90 are formed on the sapphire substrate 10. Each protrusion 90 has two rounded sides 91, and two connection sides 92 connecting the two rounded sides 91. The rounded sides 91 face a flat zone 401 of the sapphire substrate 10, i.e., a stably growing face of a nitride semiconductor. However, the sides 91 are rounded not to be parallel with the stably growing face, thereby preventing growth delay of a nitride semiconductor layer and subsequently reducing crystal defects. In the meantime, it is possible to align the rounded sides of the protrusions of array A and the rounded sides of the protrusions of array B. Here, it is necessary to guarantee a sufficient interval between arrays A and B for the growth of the nitride semiconductor. Accordingly, when the rounded sides of the protrusions of array A and the rounded sides of the protrusions of array B are arranged in alternate positions, the interval between arrays A and B can be reduced. Moreover, as compared with rectangular protrusions with straight line sides, the protrusions with the rounded sides 91 according to the present invention secure regions 93 between them. Therefore, although the interval between arrays A and B decreases, it is possible to secure a space for growing the nitride semiconductor layer.

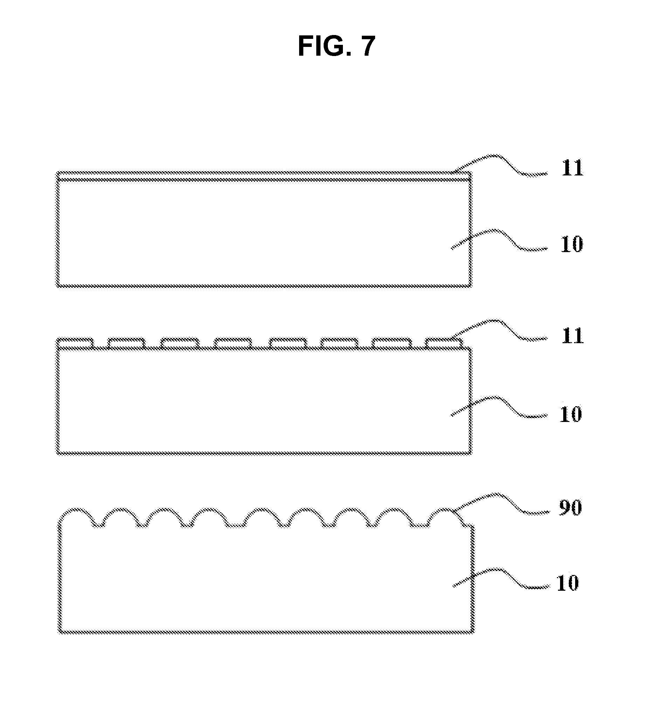

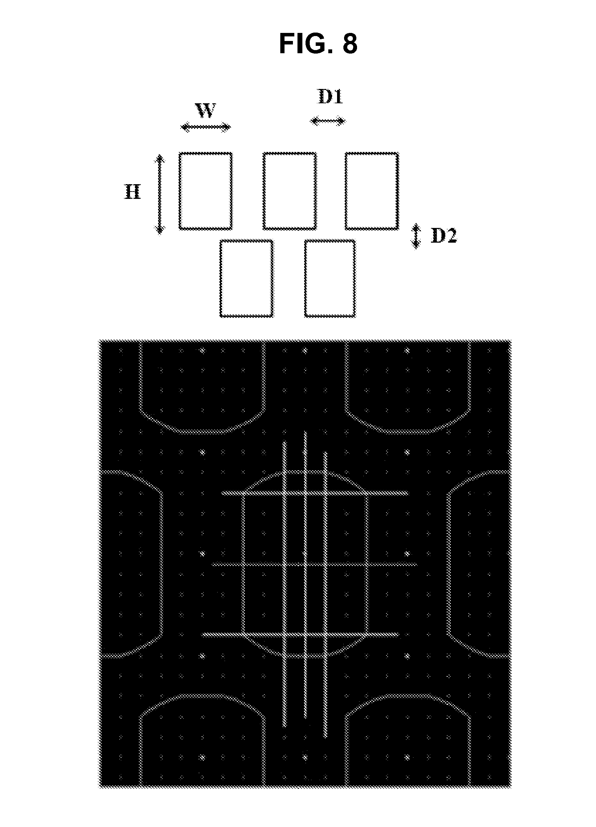

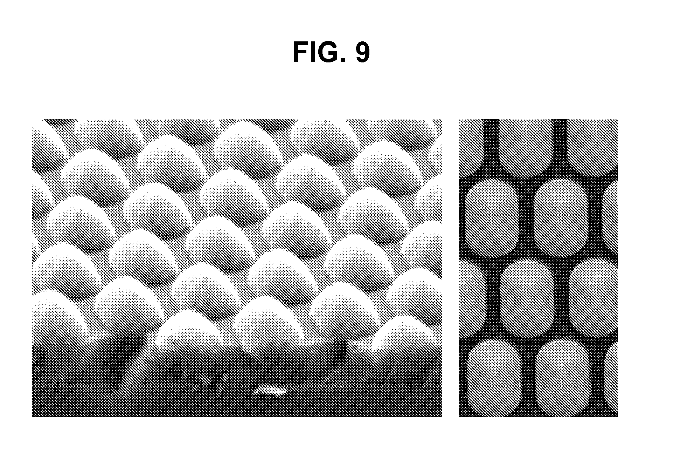

FIGS. 7 and 8 are explanatory views illustrating an example of a process of forming protrusions according to the present invention. First of all, a photoresist 11 is coated on a substrate 10, and a patterning process is carried out thereon. The patterning process is performed by means of a photo-etching process. Here, a thickness of the photoresist 11 to be coated is changed according to a height of protrusions to be formed on the substrate 10. That is, the thickness of the photoresist is adjusted according to the target height of the protrusions. FIG. 8 shows a shape of the pattern. For example, the pattern can be 4.2 µm in height H, 2.4 µm in width W, 1.6 µm in protrusion interval D1, and 0.8 µm in array interval D2, and cut in edge portions. FIG. 9 shows one example of protrusions formed by the above process. If necessary, the top surfaces of the protrusions can be flat. In this case, a nitride semiconductor is also grown on the top surfaces of the protrusions.

Thereafter, the substrate 10 is etched normally by means of a reactive ion etching (RIE). Meanwhile, edges of the mask pattern are actively etched. Even if the mask pattern is not rounded, it is possible to form the protrusion 90 according to the present invention. A pattern with rounded edges or a baking process for rounding may be used. Here, connection sides are formed in a straight line shape by the etching. In a case where the baking process is performed, the connection sides can be slightly curved.

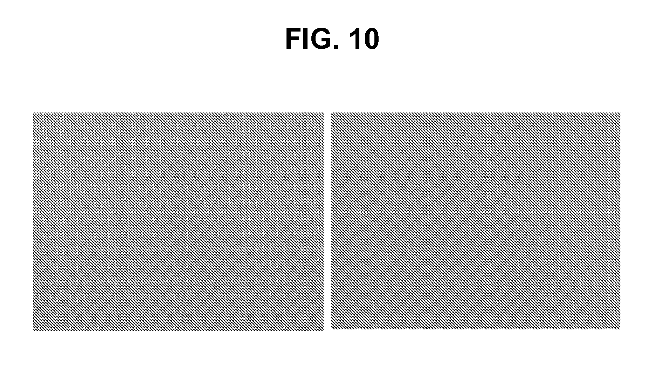

FIG. 10 is an optical microscope photograph showing a GaN epitaxial layer grown on a prepared substrate according to the present invention. On the left side, a focus was fixed on a boundary surface between the sapphire substrate and the epitaxial layer, and processed protrusions were projected on the sapphire substrate. On the right side, a focus was fixed on a surface of the epitaxial layer, and a good epitaxial crystalline layer with a smooth surface was obtained without any pit or pinhole. A GaN layer with a thickness of about 4 µm was grown by means of MOCVD as follows. A prepared substrate was positioned on a susceptor made of graphite in an MOCVD reactor. A temperature was raised to 1100 °C in a hydrogen atmosphere to remove impurities from the surface of the substrate. SiC was grown by using 4.5 µmol of DTBSi per minute and 17 µmol of CBr₄ per minute as source material. The growth temperature was 950 °C and the growth time was 60 seconds, so that the layer was formed to an estimated thickness of 10 A. Thereafter, for a surface wetting layer, InGaN was grown by using 10 µmol of TMIn per minute, 400 µmol of TMGa per minute, and 12 I of NH₃ per minute as material source. The growth temperature was 500 °C and the growth time was 35 seconds, so that the layer was grown to a thickness of 500 A. Then, an undoped GaN was formed by using 870 µmol of TMGa per minute and 18 I of NH₃ per minute as source material. The growth temperature was 1050 °C and the growth time was 7200 seconds, so that the layer was grown to a thickness of 4 µm. Crystallinity of the grown epitaxial layer could be confirmed by an XRD rocking curve measurement result. A half width of XRD (002) was ∼250 arc-second, and a half width of XRD (102) was ∼300 arc-second. That is, the epitaxial layer showed very high crystallinity.

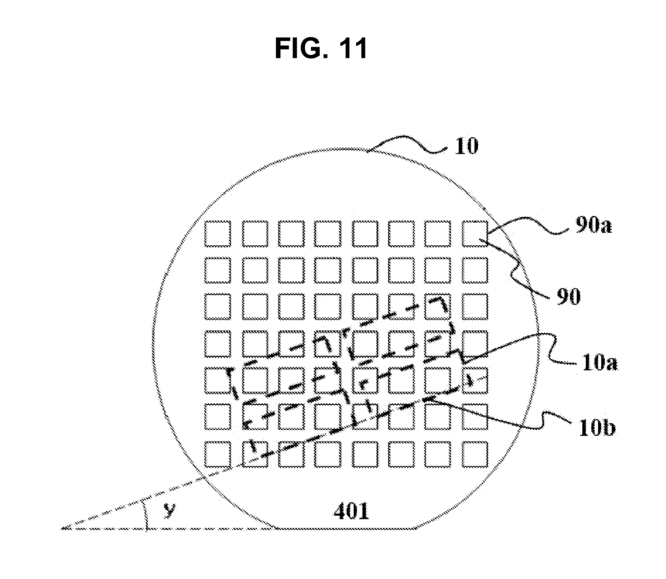

FIG. 11 is an explanatory view illustrating the relationship between a light emitting device and a scribing line. Quadrangular protrusions 90 are formed parallel to flat zone 401 of a substrate 10. Cutting surfaces 10a and 10b of each light emitting device, i.e., scribing lines are indicated by dotted lines. An amount of light to be extracted can be controlled by adjusting an angle y of the scribing line to the side of the quadrangular protrusion 90.

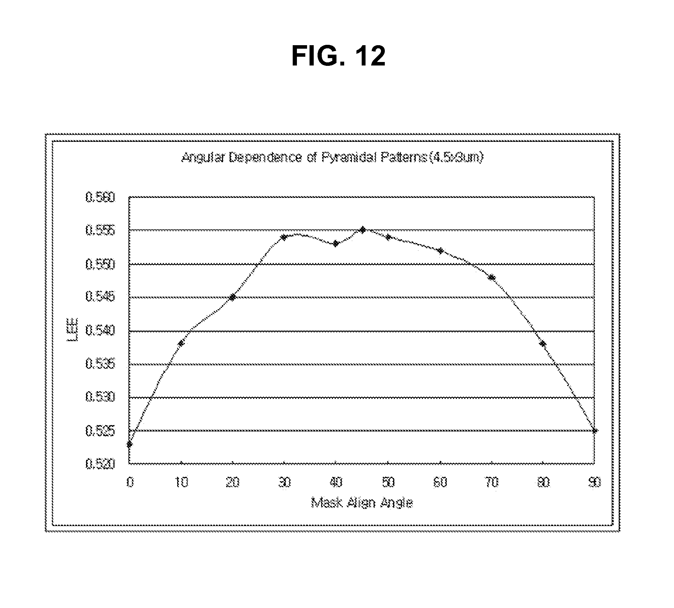

FIG. 12 is a graph showing a simulation result of analyzing light extraction efficiency variations by an angle y, using a quadrangular pyramidal protrusion with a base of 4.5 µm × 3 µm. When the angle y is about 45 °, light extraction efficiency increases. This result can be identically applied to a protrusion with rounded sides. Light Tools 5.1 program of Optical research associates was used in the simulation.

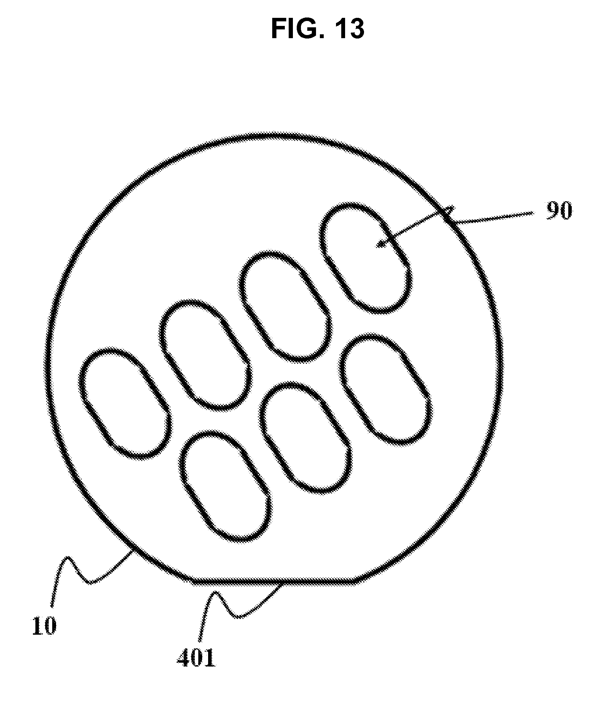

FIG. 13 is a view illustrating another example of arrangement of protrusions according to the present invention. Protrusions 90 are formed on a sapphire substrate 10 in a position rotated against a flat zone 401. In this configuration, when the result of FIG. 12 is applied to a light emitting device, a scribing line is not adjusted according to a direction of the protrusions 90, but the direction of the protrusions 90 is adjusted according to the scribing line.

## Claims

1. A III-nitride semiconductor light emitting device, comprising:
a plurality of III-nitride semiconductor layers including an active layer for generating light by recombination of electrons and holes; and
a substrate used to grow the plurality of III-nitride semiconductor layers, and including a protrusion with two opposite sides rounded.

2. The III-nitride semiconductor light emitting device of Claim 1, wherein the protrusion comprises two connection sides for connecting the two opposite rounded sides.

3. The III-nitride semiconductor light emitting device of Claim 2, wherein the substrate is divided by at least one cutting surface, and extension lines of the two connection sides cross the at least one cutting surface.

4. The III-nitride semiconductor light emitting device of Claim 3, wherein the substrate is a sapphire substrate.

5. The III-nitride semiconductor light emitting device of Claim 2, wherein the extension lines of the two connection sides cross stably growing faces of the plurality of nitride semiconductor layers.

6. The III-nitride semiconductor light emitting device of Claim 2, wherein the two connection sides are straight lines.

7. The III-nitride semiconductor light emitting device of Claim 1, wherein the two opposite rounded sides face a stably growing face of the plurality of nitride semiconductor layers.

8. The III-nitride semiconductor light emitting device of Claim 1, wherein the substrate comprises a first array with a plurality of protrusions formed thereon, and a second array with a plurality of protrusions formed thereon, and the plurality of protrusions of the first array and the plurality of protrusions of the second array are arranged in alternate positions.

9. The III-nitride semiconductor light emitting device of Claim 1, wherein the substrate is divided by at least one cutting surface, the protrusion comprises two connection straight line sides for connecting the two opposite rounded sides, extension lines of the two connection sides cross the at least one cutting surface and also cross stably growing faces of the plurality of nitride semiconductor layers, the two opposite rounded sides face a stably growing face of the plurality of nitride semiconductor layers, the substrate comprises a first array with a plurality of protrusions formed thereon, and a second array with a plurality of protrusions formed thereon, and the plurality of protrusions of the first array and the plurality of protrusions of the second array are arranged in alternate positions.

10. The III-nitride semiconductor light emitting device of Claim 9, wherein the substrate is a sapphire substrate.

11. A III-nitride semiconductor light emitting device, comprising:
a plurality of III-nitride semiconductor layers including an active layer for generating light by recombination of electrons and holes; and
a substrate used to grow the plurality of III-nitride semiconductor layers, and including a protrusion with at least two sides, the at least two sides including a rounded side facing a stably growing face of the nitride semiconductor layers.

12. The III-nitride semiconductor light emitting device of Claim 11, wherein the substrate is a sapphire substrate.

13. The III-nitride semiconductor light emitting device of Claim 11, wherein the substrate is divided by at least one cutting surface, and an extension line of the other side of the at least two sides crosses the at least one cutting surface.

14. The III-nitride semiconductor light emitting device of Claim 13, wherein the other side of the at least two sides crosses the stably growing face of the plurality of nitride semiconductor layers.

15. The III-nitride semiconductor light emitting device of Claim 11, wherein the substrate comprises a first array with a plurality of protrusions formed thereon, and a second array with a plurality of protrusions formed thereon, and rounded sides of the protrusions of the first array and rounded sides of the protrusions of the second array are arranged in alternate positions.
